# EUROPEAN PATENT SPECIFICATION

(11) **EP 0 803 485 B1**
(45) Date of publication and mention of the grant of the patent: **14.03.2001**
(21) Application number: 97106160.1
(22) Date of filing: 15.04.1997
(51) Int. Cl.: C04B 35/573

(54) **Process for production of silicon carbide shaped material**
Verfahren zur Herstellung von Formkörpern aus Siliciumcarbid
Procédé de fabrication d'un matériau moulé en carbure de silicium

(30) Priority: 22.04.1996 JP 12646596
(43) Date of publication of application: 29.10.1997
(73) Proprietor: NISSHINBO INDUSTRIES, INC., Chuo-ku, Tokyo 103 (JP)
(72) Inventor: Saito, Kazuo, c/o Nisshinbo Industries, Inc., Tokyo 123 (JP); Mochizuki, Yasushi, c/o Nisshinbo Industries, Inc., Tokyo 123 (JP); Yamamoto, Seiji, c/o Nisshinbo Industries, Inc., Tokyo 123 (JP)
(74) Representative: Laufhütte, Dieter, Dr.-Ing.

(56) References cited:
- EP-A- 0 603 888
- DE-A- 3 701 691
- CHEMICAL ABSTRACTS, vol. 123, no. 2, 10 July 1995 Columbus, Ohio, US; abstract no. 16024, K. SAITO, ET AL.: "Impervious carbon coatings, and their manufacture" XP002057475 & JP 07 097 286 A (NISSHIN SPINNING, JAPAN) 11 April 1995

## Description

### Background of the Invention

### 1. Field of the Invention

The present invention relates to a process for producing a silicon carbide shaped material which is used in applications such as semiconductor industry, electronic industry, ceramic industry, iron industry and the like (in these applications, heat resistance is required for said material).

### 2. Description of the Prior Art

Silicon carbide shaped materials used in the semiconductor industry, electronic industry, ceramic industry, iron industry, etc. have heretofore been produced by various processes. These processes include, for example, (1) a process for obtaining bonded silicon carbide particles by firing, (2) a process which comprises depositing silicon carbide on a substrate by chemical vapor deposition (CVD) and peeling the deposited silicon carbide, (3) a process which comprises bonding the particles of a carbon powder (e.g. a graphite powder) by firing and converting part of the surface of the bonded carbon material into silicon carbide, (4) a process which comprises producing a composite material by two or more of the above processes (1) to (3) in combination.

These conventional processes, however, have respective problems. Therefore, it has been desired to develop a process for producing a silicon carbide shaped material, which is free from such problems.

The process (1) for obtaining bonded silicon carbide particles by firing, comprises mixing a silicon carbide powder, metallic silicon, a metal sintering aid, etc. and firing the mixture, and is in wide use. The silicon carbide shaped material obtained by the process, however, contains generally 1% and, in some cases, 25% of metals, metal oxides, metal nitrides, etc. And accordingly, when the silicon carbide shaped material is used as a producing apparatus for the semiconductor industry, electronic industry, ceramic industry, iron industry and the like (in these applications, heat resistance is required for said material), or, jig or the like in the producing steps of such industries, causes contamination of materials (e.g. silicon wafer) with which the shaped material comes into contact.

In order to prevent the vaporization or diffusion of the metals, metal oxides, metal nitrides, etc. contained in the above silicon carbide shaped material, it was proposed to form, on the shaped material, a high-purity silicon carbide film by CVD. This film, however, is not fully satisfactory. That is, the film easily generates cracks when repeatedly subjected to a heat cycle, and the metals, metal oxides, metal nitrides, etc. vaporize through the cracks; even when no cracks are generated, the metals, metal oxides, metal nitrides, etc. diffuse into the silicon carbide film formed by CVD and finally appear on the film. Thus, the proposal does not completely solve the problems of the process (1).

The process (2), which comprises depositing silicon carbide on a substrate by CVD and peeling the deposited silicon carbide, is disclosed in, for example, Japanese Patent Application Laid-Open (Kokai) No. 53-147700 and Japanese Patent Application Laid-Open (Kokai) No. 54-43200. In this process, a silicon carbide film is grown on a substrate (e.g. a silicon substrate) by CVD and then the substrate is removed by melting or etching to obtain a film-like silicon carbide shaped material. This process, however, has problems such as the followings. Since the substrate and the silicon carbide formed thereon have different expansion coefficients, the film-like silicon carbide shaped material has warpage; further, the growth rate of silicon carbide during CVD is low, incurring a high cost; furthermore, it is difficult to obtain a silicon carbide shaped material of 1 mm or more in thickness.

The process (3), which comprises bonding the particles of a carbon powder (e.g. a graphite powder) by firing and converting part of the surface of the bonded carbon material into silicon carbide, has the following problems. When the bonded carbon material is thick, the conversion thereof into silicon carbide takes place only at the surface; moreover, the silicon carbide shaped material obtained cannot be used in applications where the shaped material is exposed to high temperatures, because the shaped material has pores and, at high temperatures, its inside undergoes oxidation and vaporizes.

Besides, there are known shaped materials obtained by coating the surface of graphite or the like with silicon carbide by CVD. Such shaped materials, however, are not substantially used now because of problems such as surface peeling, cracking and the like.

According to EP 603 888 A a method of producing silicon carbon fibers is known, wherein polyimide fibers and the like are exemplified as raw materials to be carbonized at 450°C to 1000°C. And in this invention, porous carbon fibers having fine pores of 0.5-20nm, specific surface area of 100-3000 m²/g and and thickness (diameter) of 5-100µm, are used as raw materials for conversion to the silicon carbide fibers. Fibers, which have been converted to silicon carbide are only obtained at the surface, when the porous carbon fibers having a specific surface area of 100 m²/g or smaller are used as raw materials.

### Object and Summary of the Invention

The object of the present invention is to alleviate the above-mentioned problems of the prior art and provide a process for producing a silicon carbide shaped material which has a high purity and a high density and which generates no warpage even when made into a thin material such as film or the like.

According to the present invention, there is provided a process for producing a silicon carbide shaped material, which comprises converting a polycarbodiimide resin into a shaped material of desired shape, carbonizing the shaped material at from more than 1000°C and up to 3000°C, reacting the carbonized shaped material with silicon or a silicon-containing gas and, if necessary, forming, on the resulting silicon carbide shaped material, a silicon carbide layer by CVD.

### Detailed Description of the Invention

The present invention is hereinafter described in detail.

The polycarbodiimide resin used in the present invention can be a known polycarbodiimide or can be produced by an ordinary process such as disclosed in USP No. 2,941,956; Japanese Patent Publication No. 47-33279; J. Org. Chem., 28, pp. 2069-2075 (1963); or Chemical review 1981, Vol. 81, No. 4, pp. 619-621. It can be easily produced, for example, by subjecting an organic diisocyanate to carbon dioxide removal and condensation in the presence of a carbodiimidization catalyst.

The organic diisocyanate used for production of the polycarbodiimide resin can be any of an aliphatic type, an alicyclic type, an aromatic type, an aromatic-aliphatic type, etc. They can be used singly or in combination of two or more.

The organic diisocyanate can be exemplified by 2,4-tolylene diisocyanate, 2,6-tolylene diisocyanate, a mixture of 2,4-tolylene diisocyanate and 2,6-tolylene diisocyanate, crude tolylene diisocyanate, xylylene diisocyanate, m-phenyl diisocyanate, naphthylene-1,5-diisocyanate, 4,4-biphenylene diisocyanate, 3,3-dimethoxy-4,4-biphenyl diisocyanate, and mixtures thereof.

The polycarbodiimide resin used in the present invention includes a homopolymer or copolymer comprising at least one kind of repeating unit represented by the following formula:

-R-N=C=N-

(wherein R is an organic diisocyanate residue).

The organic diisocyanate residue R in the above formula is a moiety which remains when two isocyanate (NCO) groups are removed from one organic diisocyanate molecule. R is preferably an aromatic diisocyanate residue. Examples of such a polycarbodiimide resin include the following compounds

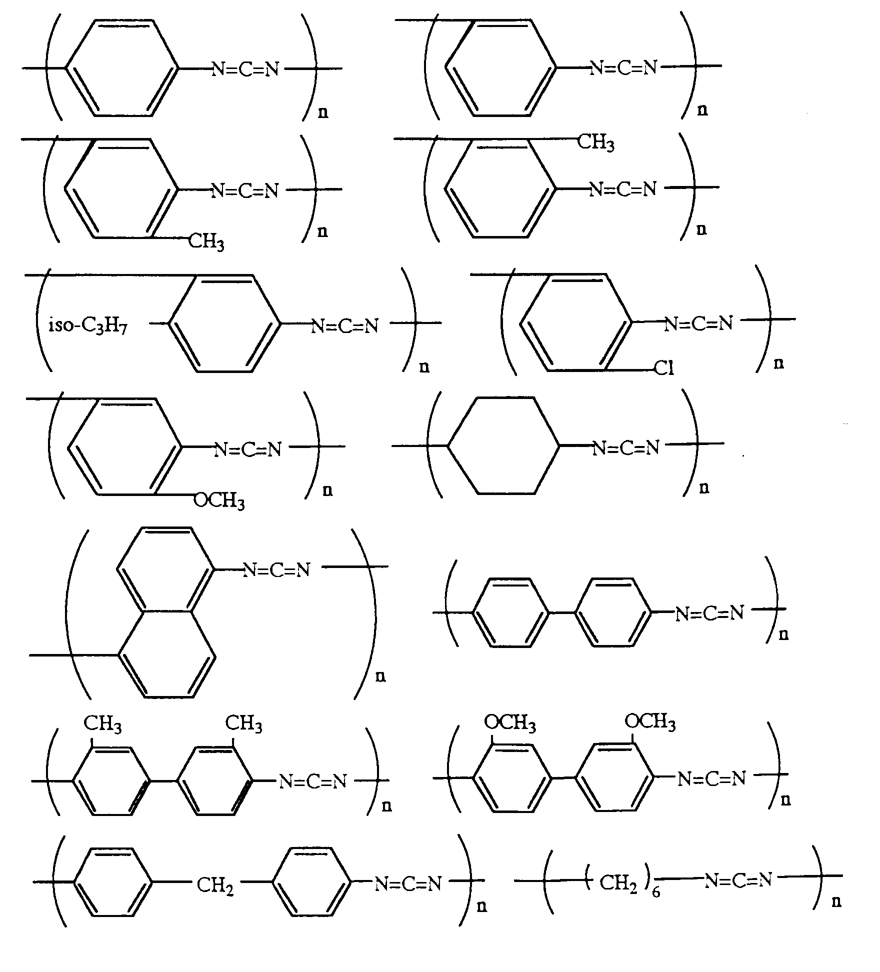

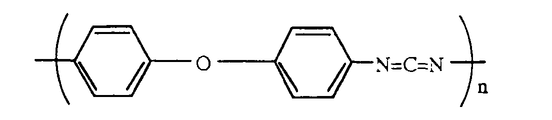

In the above formulas, n is 10-10,000, preferably 50-5,000. The terminals of the above polycarbodiimide resins may be blocked with a monoisocyanate or the like for molecular weight control. Such a monoisocyanate can be exemplified by phenyl isocyanate, o-, m- or p-tolyl isocyanate, dimethylphenyl isocyanate, cyclohexyl isocyanate and methyl isocyanate.

The polycarbodiimide resin can be obtained in a solution form, or as a powder obtained from the solution by precipitation. The thus-obtained polycarbodiimide resin, when obtained in a solution form, can be used as it is or after removing the solvent by distillation and, when obtained as a powder, can be used as it is or after dissolving it in a solvent and converting into a solution.

In the process of the present invention, the polycarbodiimide resin is first converted into a polycarbodiimide shaped material of desired shape. The shape is not particularly restricted and may be a simple shape (e.g. a film or a sheet) or a complicated shape used as a member of the producing apparatus for the semiconductor industry, electronic industry, ceramic industry, iron industry and the like (in these applications, heat resistance is required for said material), or, jig or the like in the producing steps of such industries.

The method used for converting the polycarbodiimide resin into a shaped material can be one ordinarily used in obtaining such a shaped material and has no particular restriction. It includes, for example, injection molding, compression molding, cast molding, vacuum molding and extrusion molding.

The polycarbodiimide resin shaped material is then heated and carbonized to obtain a carbonized shaped material. This carbonization step can be conducted in vacuum or in an inert atmosphere (e.g. a nitrogen gas). In the step, the final firing temperature is from more than 1,000-up to 3,000°C.

In the process of the present invention, the carbonized shaped material is reacted with silicon to obtain a silicon carbide shaped material. An ordinary method can be used for the reaction of carbon with silicon and there is no particular restriction for the reaction.

That is, when the carbonized shaped material is reacted with metallic silicon, they are contacted with each other in various ways and then heated. For example, the carbonized shaped material is laminated with metallic silicon of sheet form, or is covered with a metallic silicon powder or a shaped silicon material, or is covered with metallic silicon by vapor deposition or sputtering.

Or, the carbonized shaped material is placed in molten metallic silicon, once cooled and then heated. The heating temperature is about 1,000-3,000°^{C}, preferably 1,200-2,100°^{C}.

When the carbonized shaped material is reacted with silicon in a gas phase, the carbonized shaped material is contacted with a silicon-containing gas in an oven, followed by heating. The silicon-containing gas includes, for example, SiO, Si vapor, SiCl₄, SiH₄ and SiHCl₃. The heating temperature is about 1,000-2,300°^{C}, preferably about 1,200-2,100°^{C}.

In the process of the present invention, a silicon carbide layer may be formed on the above-obtained silicon carbide shaped material, by CVD. In this step, an ordinary CVD method can be employed with no particular restriction. For example, the silicon carbide shaped material is placed in a reaction chamber; into the chamber is introduced a mixed gas consisting of a halogenated organosilicon compound and hydrogen; the halogenated organosilicon compound is reduced and heat-decomposed and the resulting silicon carbide vapor is deposited on the silicon carbide shaped material.

The halogenated organosilicon compound, which is a silicon source, includes, for example, CH₃SiCl₃, C₆H₅SiCl₃, (CH₃)₂SiCl₂, CH₃SiHCl₃, (CH₃)₃SiCl, SiH₂Cl₂, SiH₄/CH₄ and SiCl₄/CH₄. The reaction temperature is about 900-1,800°^{C}, preferably about 1,000-1,700°^{C}.

In the present process, since a polycarbodiimide resin of good moldability is used as a starting material, the silicon carbide shaped material obtained can have not only a simple shape such as sheet, foam, fiber, powder, bulk or the like, but also a complicated shape such as a member of the producing apparatus for the semiconductor industry, electronic industry, ceramic industry, iron industry and the like (in these applications, heat resistance is required for said material), or, jig or the like in the producing steps of such industries.

Although the reasons are not clear, the polycarbodiimide resin can be easily converted into a silicon carbide of high purity, and accordingly, the silicon carbide shaped material of high purity and high density which generates no warpage even when made in a thin material such as film or the like can be obtained.

When a silicon carbide layer is formed by CVD on the silicon carbide shaped material, the shaped material is covered with a CVD silicon carbide layer of even higher purity. In this shaped material, since the main body and the CVD layer are made each of substantially the same material, they show high adhesivity to each other.

The present invention is described in more detail below by way of Examples.

### Example 1

### [Production of polycarbodiimide resin 1]

54 g of TDI (a 80/20 mixture of 2,4-tolylene diisocyanate and 2,6-tolylene diisocyanate) was reacted in 500 ml of tetrachloroethylene in the presence of 0.12 g of a carbodiimidization catalyst (1-phenyl-3-methylphosphorene oxide) at 120°C for 5 hours to obtain a solution of a polycarbodiimide resin 1.

### [Production of carbon sheet]

The above solution of a polycarbodiimide resin 1 was poured into a laboratory dish, dried at 60°C for 20 hours and at 120°C for 20 hours, and then heated to 200°C at a temperature elevation rate of 1°C/hr to obtain a cured sheet. The cured sheet was heated, for firing, in a nitrogen gas current up to 2,000°C at a temperature elevation rate of 2°C/hr to obtain a carbon sheet of 6 mm (thickness), 200 mm (diameter), 1.55 g/cm³ (bulk density) and 0% (porosity).

### Example 2

### [Production of carbon foam (porous material)]

With carbon dioxide gas being bubbled, the polycarbodiimide resin 1 solution obtained in Example 1 was dried at 60°C for 20 hours and at 120°C for 20 hours. The dried material was heated to 200°C at a temperature elevation rate of 1°C/hr to obtain a cured polycarbodiimide foam. The foam was heated, for firing, in a nitrogen gas current up to 2,000°C at a temperature elevation rate of 2°C/hr to obtain a carbon foam (porous material) of 10 mm (thickness), 0.02 g/cm³ (bulk density) and 95% (porosity).

### Example 3

### [Production of carbon fiber]

The polycarbodiimide resin 1 solution obtained in Example 1 was concentrated to a concentration of 30% by weight and subjected to dry spinning to obtain a polycarbodiimide resin fiber. This resin fiber was heat-treated at 60°C for 2 hours and at 200°C for 2 hours to obtain a cured fiber. The cured fiber was heated, for firing, in a nitrogen gas current up to 2,000°C at a temperature elevation rate of 20°C/hr to obtain a carbon fiber of 10 µm (diameter).

### Example 4

### [Production of polycarbodiimide resin 2]

50 g of MDI (methylene diphenyl diisocyanate) was reacted in 880 ml of tetrachloroethylene in the presence of 0.12 g of a carbodiimidization catalyst (1-phenyl-3-methylphosphorene oxide) at 120°C for 15 hours to obtain a polycarbodiimide solution. The solution was returned to room temperature, whereby a polycarbodiimide resin was precipitated. The precipitated resin was collected by filtration using a filter paper and dried at 60 °C for 40 hours to obtain a powder of a polycarbodiimide resin 2.

### [Production of carbon powder]

The polycarbodiimide resin 2 powder was heated, for firing, up to 2,000°C in a nitrogen gas current at a temperature elevation rate of 2°C/hr to obtain a carbon powder of 0.8 mm (particle diameter).

### Example 5

### [Production of carbon sheet]

The polycarbodiimide resin 2 powder obtained in Example 4 was placed in a mold and subjected to compression molding at a temperature of 120°C to obtain a resin shaped material. The resin shaped material was heated, for firing, up to 2,000°C in a nitrogen gas current at a temperature elevation rate of 2°C/hr to obtain a carbon sheet of 20 mm (thickness), 200 mm (diameter), 1.45 g/cm³ (bulk density) and 3% (porosity).

### Comparative Example 1

### [Production of carbon sheet]

A carbon sheet of 10 mm (thickness) and 200 mm (diameter) was produced using isotropic graphite having bulk density of 1.82 g/cm³.

### Comparative Example 2

### [Production of carbon sheet]

A carbon sheet of 10 mm (thickness) and 200 mm (diameter) was produced using carbonaceous graphite having bulk density of 1.75 g/cm³.

### Reaction with silicon (solid-phase reaction)

In a metallic silicon powder having an average particle diameter of 5 µm and a purity of 99.999% was placed each of the carbon shaped materials obtained above, i.e. the carbon sheet of Example 1, the carbon foam of Example 2, the carbon fiber of Example 3, the carbon powder of Example 4, the carbon sheet of Example 5, the carbon sheet of Comparative Example 1 and the carbon sheet of Comparative Example 2. The silicon powder containing each carbon shaped material was heat-treated in vacuum at 1,400°C in an oven to produce respective silicon carbide shaped materials. As a result, in each of the silicon carbide shaped materials of Examples 1 to 5, conversion into silicon carbide was made completely as far as the inside; while in the silicon carbide shaped materials of Comparative Examples 1 and 2, conversion into silicon carbide was made only at the surface, and the inside remained as carbon.

As shown in Table 1, the silicon carbide shaped materials of Examples 1 and 5 gave substantially no warpage, while the carbon sheets of Comparative Examples 1 and 2 gave warpage.

Each of the above-obtained silicon carbide shaped materials was dipped in a mixed acid (HF/NNO₃) and measured for weight change. Also, each silicon carbide shaped material was heated in air at 1,000°C for 100 hours and measured for weight change. Also, each silicon carbide shaped material was subjected repeatedly to a heat cycle test which comprised heating the shaped material to 1,200°C in an argon current and placing the heated material in water of 20°C for quenching, to examine the number of cycles when first cracking appeared. The results obtained are shown in Table 1.

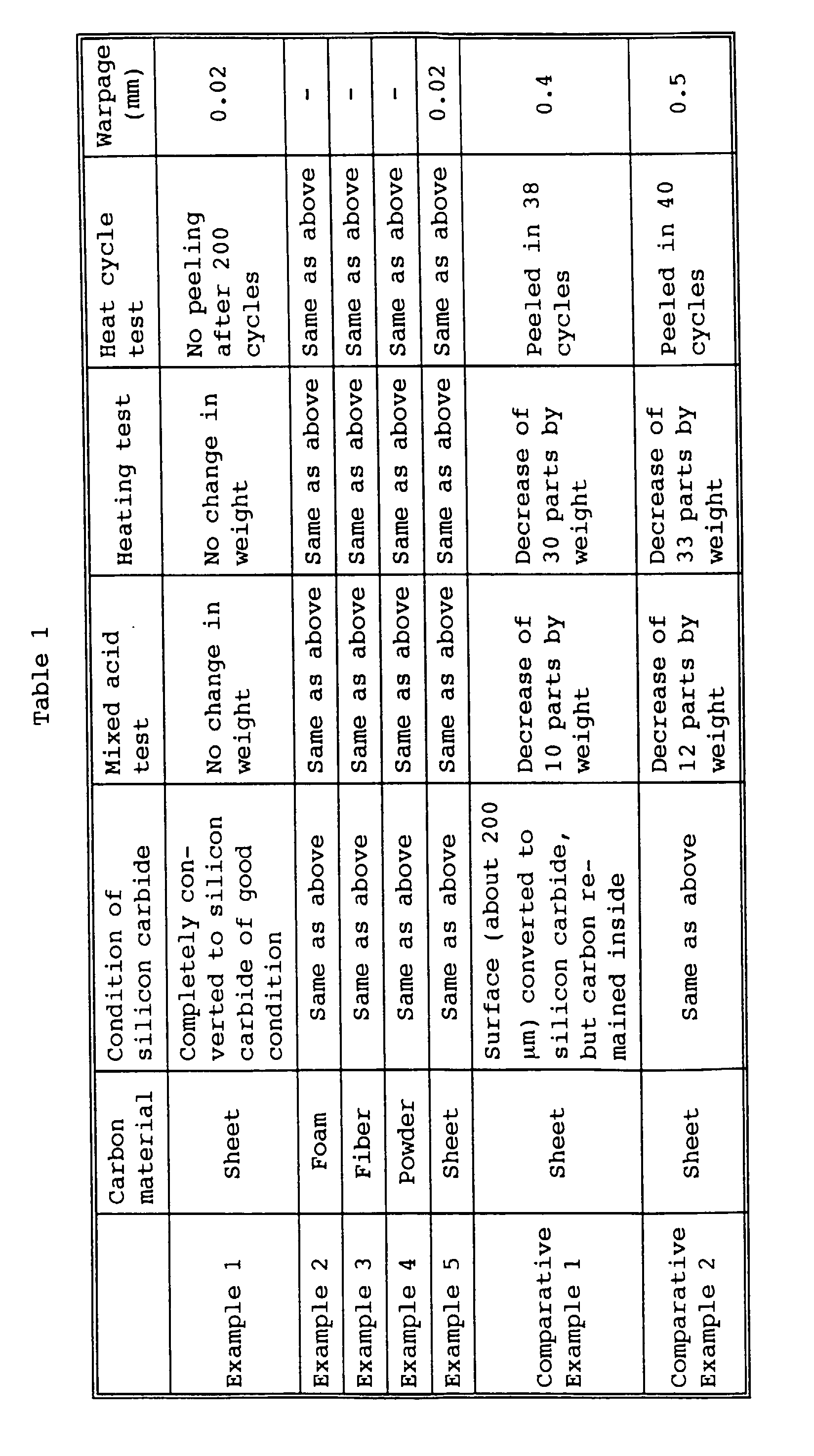

### Reaction with silicon (gas-phase reaction)

### Examples 6-10 and Comparative Examples 3-4

The carbonized shaped materials produced in Examples 1-5 and Comparative Examples 1-2 were placed in an oven and heat-treated at 2,000°C in a current of a mixed gas consisting of argon and SiHCl₃ to produce silicon carbide shaped materials. As a result, in each of the silicon carbide shaped materials of Examples 6 to 10 (produced from the carbon sheet of Example 1, the carbon foam of Example 2, the carbon fiber of Example 3, the carbon powder of Example 4 and the carbon sheet of Example 5, respectively), conversion into silicon carbide was made completely as far as the inside; while in the silicon carbide shaped materials of Comparative Examples 3 and 4 (produced from the carbon sheet of Comparative Example 1 and the carbon sheet of Comparative Example 2, respectively), conversion into silicon carbide was made only at the surface, and the inside remained as carbon.

As shown in Table 2, the silicon carbide shaped materials of Examples 6 and 10 gave substantially no warpage, while the carbon sheets of Comparative Examples 3 and 4 gave warpage.

Each of the above-obtained silicon carbide shaped materials was dipped in a mixed acid (HF/NNO₃) and measured for weight change. Also, each silicon carbide shaped material was heated in air at 1,000°C for 100 hours and measured for weight change. Also, each silicon carbide shaped material was subjected repeatedly to a heat cycle test which comprised heating the shaped material to 1,200°C in an argon current and placing the heated material in water of 20°C for quenching, to examine the number of cycles when first cracking appeared. The results obtained are shown in Table 2.

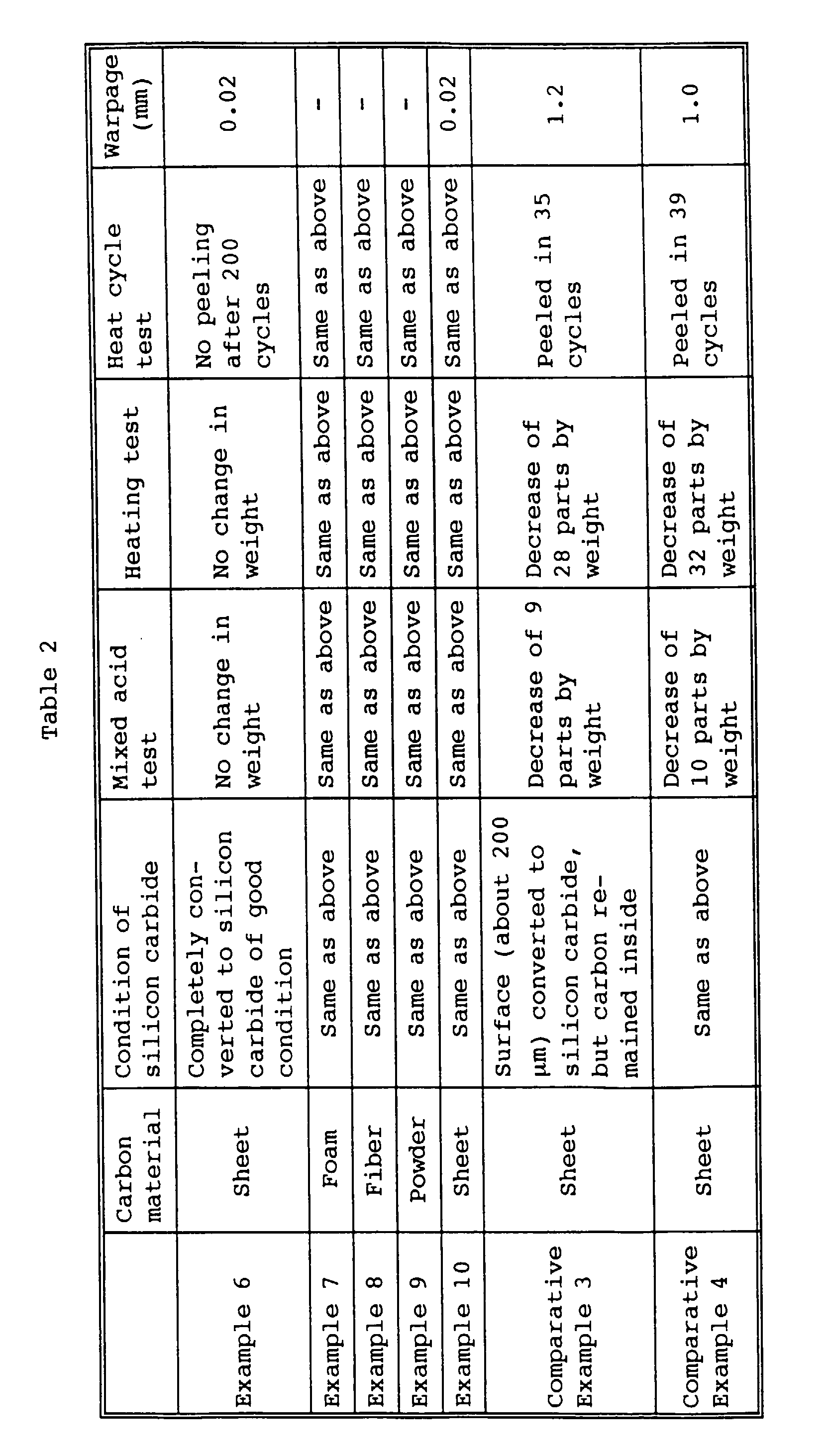

### Reaction with silicon (coating by CVD)

### Examples 11-15 and Comparative Examples 5-6

Each of the silicon carbide shaped materials produced in Examples 6-10 and Comparative Examples 3-4 was placed in a CVD vessel; a mixed gas consisting of hydrogen and CH₃SiCl₃ was introduced; and CVD coating was conducted at 1,300°C to form a silicon carbide layer of 120 µm in thickness on each shaped material. As a result, apparently good coating was made in all the shaped materials.

Each of the above-obtained silicon carbide shaped materials was dipped in a mixed acid (HF/NNO₃) and measured for weight change. Also, each silicon carbide shaped material was heated in air at 1,000°C for 100 hours and measured for weight change. Also, each silicon carbide shaped material was subjected repeatedly to a heat cycle test which comprised heating the shaped material to 1,200°C in an argon current and placing the heated material in water of 20°C for quenching, to examine the number of cycles when first cracking appeared. The results obtained are shown in Table 3.

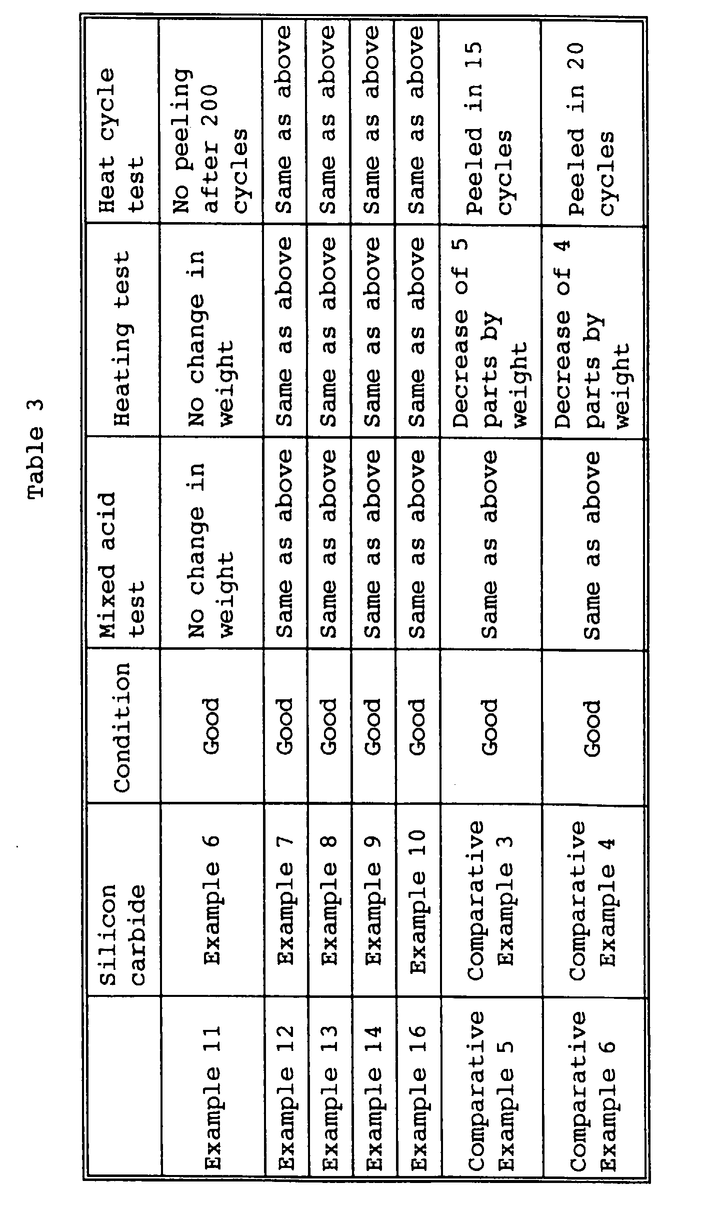

### Comparative Examples 7-9

A glassy carbon sheet of 6 mm (thickness) and 1.45 g/cm³ (bulk density) was produced from a furan resin in accordance with the procedure of Example 1. The sheet was subjected to the same solid-phase reaction, gas-phase reaction and coating by CVD as mentioned above. Each of the resulting sheets was subjected to the same mixed acid test, heating test and heat cycle test as mentioned above. The results obtained are shown in Table 4.

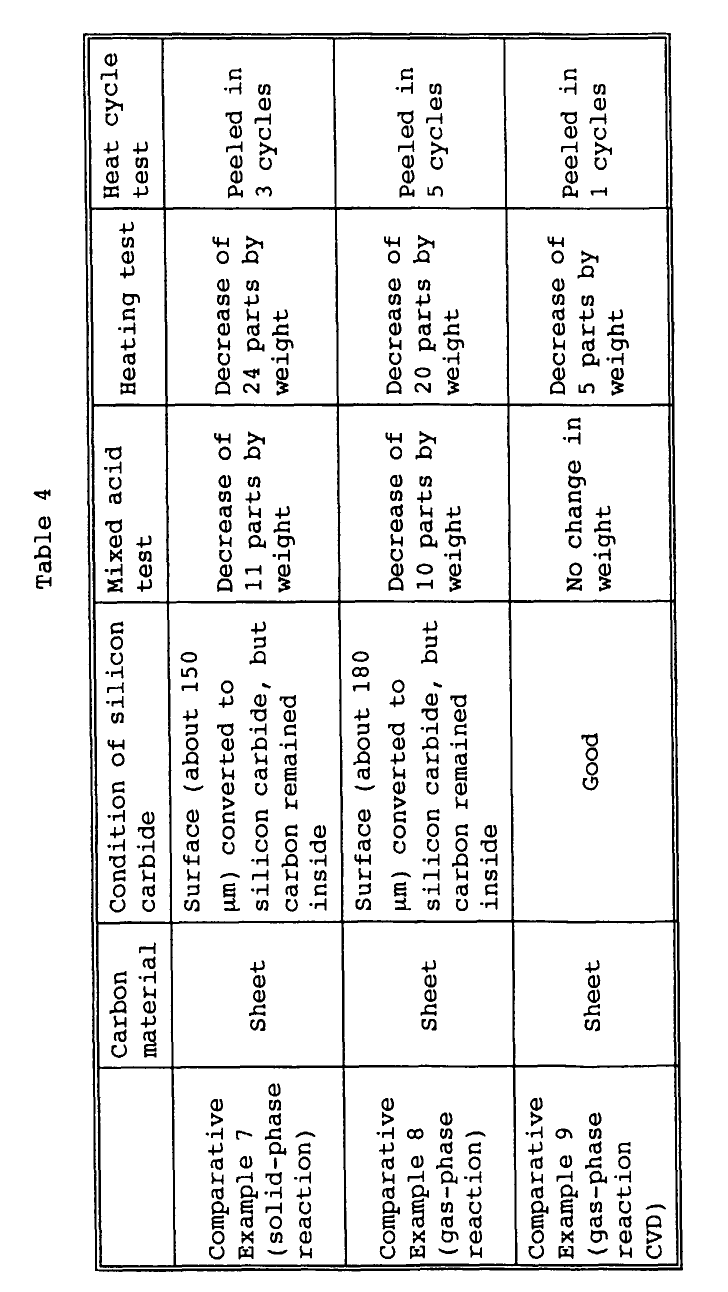

As demonstrated above, the process of the present invention enables production of a high-purity, high-density silicon carbide shaped material of simple or complicated shape which gives no warpage even when made in a thin material such as film or the like. When a silicon carbide layer is formed on the silicon carbide shaped material by CVD, the layer has high adhesivity to the shaped material.

Therefore, the present process is very useful for production of a silicon carbide shaped material which is used in applications such as semiconductor industry, electronic industry, ceramic industry, iron industry and the like (in these applications, heat resistance is required for said material).

## Claims

1. A process for producing a silicon carbide shaped material, which comprises converting a polycarbodiimide resin into a shaped material of desired shape, carbonizing the shaped material in an inert atmosphere from more than 1,000 and up to 3,000 °C, and reacting the carbonized shaped material with silicon or a silicon-containing gas.

2. A process according to claim 1 which further comprises the following step: Forming, on the resulting silicon carbide shaped material, a silicon carbide layer by CVD.

## Patentansprüche

1. Verfahren zur Herstellung eines Formkörpers aus Siliciumcarbid, welches das Umformen eines Polycarbodiimidharzes zu einem Formkörper von gewünschter Form, das Carbonisieren des Formkörpers in einer inerten Atmosphäre von mehr als 1.000 und bis zu 3.000°C und das Umsetzen des carbonisierten Formkörpers mit Silicium oder einem siliciumhaltigen Gas umfasst.

2. Verfahren nach Anspruch 1, welches außerdem die folgenden Schritte umfasst: Bilden, auf dem resultierenden Siliciumcarbid-Formkörper, einer Siliciumcarbid-Schicht mittels CVD.

## Revendications

1. Procédé de production d'un matériau façonné en carbure de silicium, qui comprend la conversion d'une résine de polycarbodiimide en un matériau façonné de la forme souhaitée, la carbonisation du matériau façonné dans une atmosphère inerte à partir de plus de 1000°C et jusqu'à 3000°C, et la réaction du matériau façonné carbonisé avec du silicium ou un gaz contenant du silicium.

2. Procédé selon la revendication 1, qui comprend de plus l'étape suivante : former, sur le matériau façonné en carbure de silicium résultant, une couche de carbure de silicium par CVD.
